# EUROPEAN PATENT APPLICATION

(11) **EP 0 772 230 A1**
(43) Date of publication of application: **07.05.1997**
(21) Application number: 96117289.7
(22) Date of filing: 28.10.1996
(51) Int. Cl.: H01L 21/205, C30B 25/02

(54) **Method of epitaxial growth of a film for semiconductor devices**

(30) Priority: 30.10.1995 JP 281543/95
(71) Applicant: NEC CORPORATION, Tokyo (JP)
(72) Inventor: Aoyama, Tohru, Minato-ku, Tokyo (JP)
(74) Representative: Glawe, Delfs, Moll & Partner

(57) **Abstract**

Disclosed herein is a method of epitaxial film growth of silicon or a silicon-germanium alloy on a silicon substrate by ultrahigh-vacuum chemical vapor deposition. The method prevents the presence of high-concentration carbon at the interface between the epitaxial film and the silicon substrate in cases where pretreatment with an aqueous hydrogen fluoride solution is performed to remove the oxide film on the substrate surface. The temperature for growing the epitaxial film is set to be within a range of 650°C to 800°C, inclusive. This temperature condition allows, during epitaxial growth, site exchange between silicon atoms in an outermost surface layer and carbon atoms in a second layer below the growth surface, resulting in an upward movement and segregation of the carbon atoms onto the growth surface. Thus, carbon concentration at the interface between the epitaxial film and the silicon substrate is decreased.

## Description

### BACKGROUND OF THE INVENTION

### 1. Field of the Invention

The present invention relates to a method of epitaxial film growth for fabricating a semiconductor device, and more particularly to a method of forming an epitaxial film of silicon based material on a single-crystal silicon substrate by chemical vapor deposition (CVD).

### 2. Description of the Related Art

Recently, ultrahigh-vacuum CVD (UHV-CVD) equipment which allows setting of the internal pressure of the chamber (reaction vessel) to 10⁻⁹ Torr or lower is being used to grow an epitaxial film of silicon (Si) or an epitaxial film of a silicon-germanium (SiGe) alloy on a semiconductor substrate. Use of ultrahigh-vacuum CVD equipment allows suppression of the partial pressure of oxygen inside the chamber and thus enables epitaxial growth at relatively low temperatures such as near 600°C.

For epitaxial growth of a silicon film or the like on a silicon substrate, it is necessary to perform pretreatment to remove the silicon oxide film formed on the silicon substrate. In a conventional pretreatment method using ultrahigh-vacuum CVD, silicon oxide film is removed by vaporization. This is done by reacting the silicon oxide and the silicon substrate through thermal treatment in a ultrahigh- vacuum atmosphere, thereby producing highly volatile SiO molecules. Since the treatment temperature must be high enough to attain the reaction, this thermal treatment must be performed at a temperature of 900°C or higher. Because the epitaxial growth itself can be performed at a relatively lower temperature, the maximum temperature throughout the process is set by this rather high pretreatment temperature. The temperature of 900°C is sufficiently high to allow diffusion of an impurity such as boron (B) or phosphorus (P) doped for control of the conductivity type of the semiconductor substrate. In the past, the distance of diffusion of the boron, phosphorus or the like during the thermal pretreatment was negligibly small as compared with the dimesnsion of the devices, and thus impurity diffusion did not constitute a problem. Recently, however, the designed junction depths are decreasing with increased degree of miniaturization of device structures, and thus the diffusion of impurities during pretreatment has become a problem for fabrication of highly integrated semiconductor devices.

For this reason, a process for removing the silicon oxide film at a low temperature has become necessary, so that a pretreatment technique involving immersion of the silicon substrate in an aqueous hydrogen fluoride (HF) solution at room temperature is being studied. Pretreatment with an aqueous hydrogen fluoride solution followed by epitaxial growth in ultrahigh-vacuum CVD equipment has been successful in producing epitaxial films free of defects detectable by an electron microscope or by observation of etch pits through selective etching.

However, the aqueous hydrogen fluoride solution treatment fails to remove carbon impurities on the surface of the silicon substrate, and thus presents the problem of creating a high concentration of carbon at the interface of the epitaxial film and the silicon substrate. This results because it is difficult to remove carbon contamination on the silicon substrate by the aqueous hydrogen fluoride solution treatment.

In the thermal pretreatment method explained above, high-temperature treatment under ultrahigh-vacuum causes carbon atoms adhered on the silicon oxide film to combine with oxygen atoms and thus to be removed by vaporization. Therefore, the conventional thermal pretreatment method presented no problem of residual carbon at the epitaxial film-silicon substrate interface. In contrast, the pretreatment with an aqueous hydrogen fluoride solution fails to eliminate the carbon due to absence of oxygen capable of combining with the carbon on the surface of the silicon substrate, and therefore carbon cannot be eliminated by a subsequent thermal treatment in the UHV-CVD chamber. Thus, carbon is left at the interface when the epitaxial growth is continued.

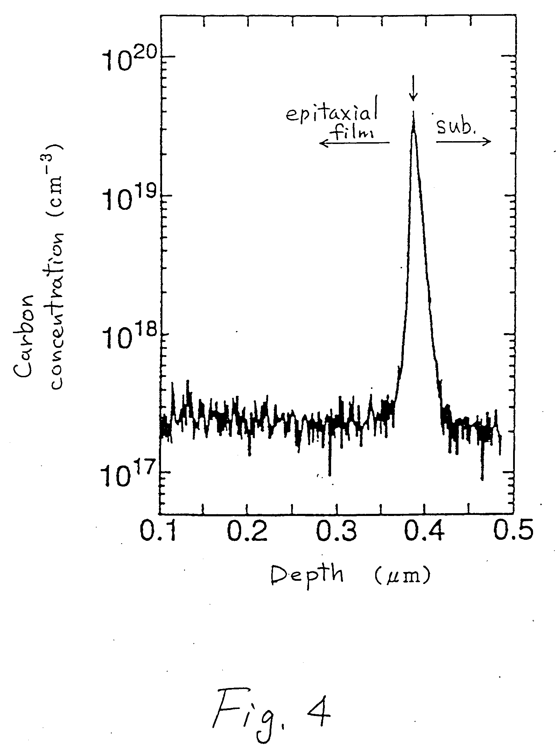

Fig. 4 is a SIMS (Secondary Ion Mass Spectroscopy) profile of carbon in an epitaxial film grown on a silicon substrate after pretreatment with an aqueous hydrogen fluoride solution. In the drawing, "depth" stands for distance from the epitaxial film surface. The epitaxial growth was performed by ultrahigh-vacuum CVD under conditions of a substrate temperature of 625°C and a pressure of 5 × 10⁻⁴ Torr, using Si₂H₆ as the material source gas. The drawing shows the presence of carbon in a high concentration of 5 × 10¹⁹ cm⁻³ at the interface between the epitaxial film and the silicon substrate. The presence of high-concentration carbon at the interface causes crystalline defects, and presents the problem of admitting a larger leakage current across the PN junction and otherwise adversely effecting the electrical characteristics of a semiconductor device.

### SUMMARY OF THE INVENTION

It is therefore an object of the present invention to prevent the presence of high-concentration carbon at the interface between an epitaxial film and a silicon substrate during formation of the epitaxial film on the silicon substrate by ultrahigh-vacuum CVD even in cases where pretreatment with an aqueous hydrogen fluoride solution is performed.

The present invention is based on a discovery by the present inventors that setting of the temperature for growing an epitaxial film by ultrahigh-vacuum CVD to a temperature within a certain range around 725°C causes a so called "surface segregation" phenomenon in which, during epitaxial growth, carbon atoms present on the surface of the single-crystal silicon substrate move up toward the surface of the epitaxial film to decrease the carbon concentration at the epitaxial film-silicon substrate interface. Therefore, the method of epitaxial film growth for fabricating a semiconductor device according to the present invention, which is a method of epitaxial film growth on a silicon substrate by ultrahigh-vacuum chemical vapor deposition, is characterized by removing the silicon oxide film on the surface of a silicon substrate with an aqueous hydrogen fluoride solution, and then growing an epitaxial film on the surface of the silicon substrate at a growth temperature of 650°C to 800°C. Preferably, the growth temperature is set in the range of 650°C to 775°C.

### BRIEF DESCRIPTION OF THE DRAWINGS

The above and other objects, advantages and features of the present invention will be more apparent from the following description taken in conjunction with the accompanying drawing in which:
Fig. 1(a) through Fig. 1(c) are cross sectional views in schematic form, illustrative of upward movement (surface segregation) of carbon atoms during growth of an epitaxial film;
Fig. 2 is a SIMS profile depicting carbon distribution along the depth of the epitaxial film shown in Example 1;
Fig. 3 is a SIMS profile depicting the carbon distribution along the depth of the epitaxial film shown in Example 1, but grown at a lower partial pressure of the material gas; and
Fig. 4 is a SIMS profile depicting the carbon distribution along the depth of an epitaxial film fabricated under conventional growth conditions.

### DETAILED DESCRIPTION OF THE PREFERRED EMBODIMENTS

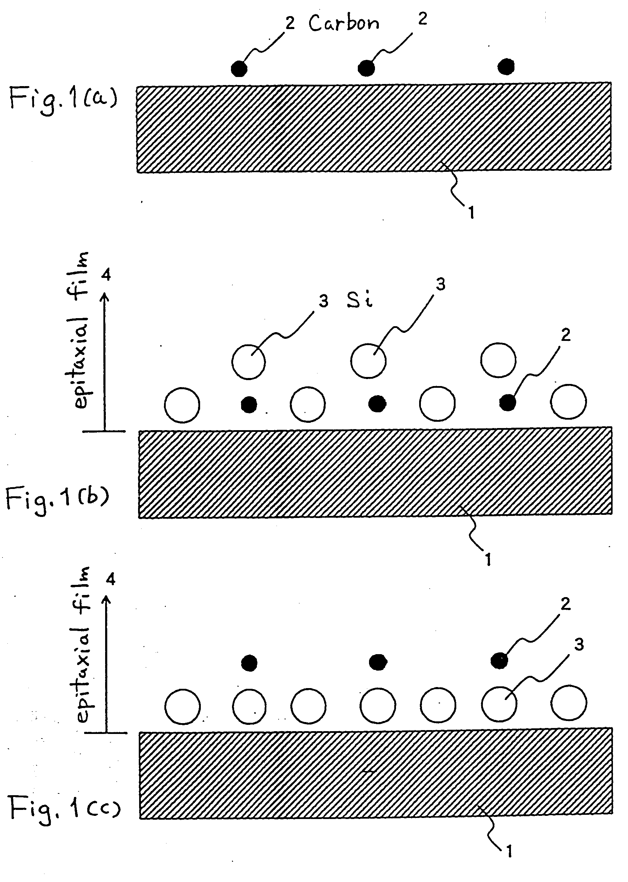

Embodiments of the present invention will now be explained with reference to the drawings. Fig. 1(a) through Fig. 1(c) are schematic views illustrative of upward movement of carbon atoms during the process of epitaxial growth on a silicon substrate 1.

In Fig. 1(a), the silicon oxide film on the substrate surface has been already removed by treatment with an aqueous hydrogen fluoride solution. As shown in Fig. 1(a), carbon atoms 2 are adhered on the surface of the silicon substrate 1 before epitaxial growth begins. As a silicon epitaxial film 4 grows, silicon atoms 3 are deposited on the silicon substrate 1, as shown in Fig. 1(b). Here, the "upward movement of carbon atoms" refers to a phenomenon in which, during growth of the epitaxial film 4, the silicon atoms 3 supplied on the silicon substrate 1 are interchanged with the underlying carbon atoms 2 to cause segregation of the carbon atoms 2 onto the growing surface (growth front). This situation is shown in Fig. 1(b) and Fig. 1(c). The present inventors have experimentally discovered that the "upward movement" phenomenon, i.e., surface segregation occurs under specific conditions, and eventually the carbon concentration at the epitaxial film-silicon substrate interface decreases. More specifically, it has been found that for occurrence of the upward movement, the growth temperature must be 650°C or higher to produce the energy necessary to overcome the potential barrier against the site interchange between the silicon atoms and the carbon atoms. On the other hand, silicon and carbon strongly react with each other to form silicon carbides at temperatures above approximately 800°C, so that the upward movement does not occur. This means that the upward movement of the carbon occurs within a limited range of 650°C to 800°C, inclusive.

It has also been found that the degree of surface segregation is determined by the ratio of a rate of site exchange between the silicon atoms in an outermost first surface layer and the carbon atoms in a second surface layer on the growth surface of the epitaxial film over the growth rate of the epitaxial film. Accordingly, under conditions of increased film growth rates, no surface segregation of carbon occurs, and reduction in the carbon concentration at the epitaxial film-silicon substrate interface cannot be accomplished. Conversely, the upward movement of the carbon is promoted by suppressing the growth rate through reduction of the partial pressure of the source gas. From this point of view, the pressure during epitaxial growth is preferably set to be less than or equal to 5 × 10⁻⁴ Torr when the present invention is carried out.

According to the present invention, the epitaxial film is composed of silicon or a silicon-germanium alloy, for example. As an example, disilane (Si₂H₆) is used as the source gas for epitaxial growth of a silicon film, while a mixed gas of disilane and germane (GeH₄) is used as source gases for epitaxial growth of a silicon-germanium alloy film.

### EXAMPLES

### Example 1

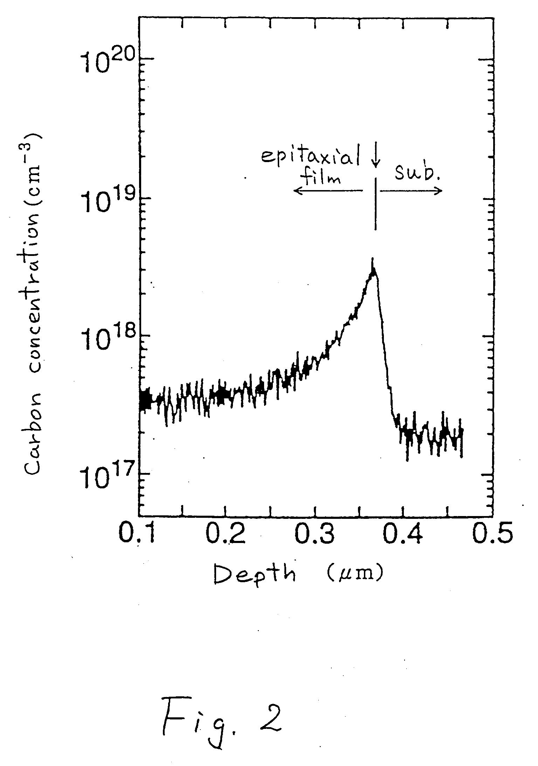

A single-crystal silicon (001) substrate was subjected to treatment with hydrofluoric acid to remove the silicon oxide film on the surface, and growth of an epitaxial film of silicon was then performed at a substrate temperature of 700°C in a ultrahigh-vacuum CVD apparatus. The treatment with hydrofluoric acid was effected by immersion of the silicon substrate in an aqueous hydrogen fluoride solution (HF : H₂O = 1 : 100) for 30 seconds, followed by rinsing with deionized water for 2 minutes. The source gas used for the growth of the epitaxial film was Si₂H₆ at a partial pressure of 5 × 10⁻⁴ Torr. The epitaxial film grown in this way was examined by SIMS for the carbon concentration distribution along its depth. The results are shown in Fig. 2. Although the carbon concentration peaks at the epitaxial film-silicon substrate interface, this peak concentration is as low as approximately one twentieth that according to the conventional technique where the growth was effected at 625°C (*cƒ.* Fig. 4). The profile of carbon decreases exponentially toward the substrate surface, and since this decay distance has a far greater dimension than a decay distance due to diffusion alone, it is a clear illustration of the upward movement of carbon toward the growth surface during epitaxy. It is concluded that the upward movement of the carbon atoms resulted in the lower carbon concentration at the interface.

### Example 2

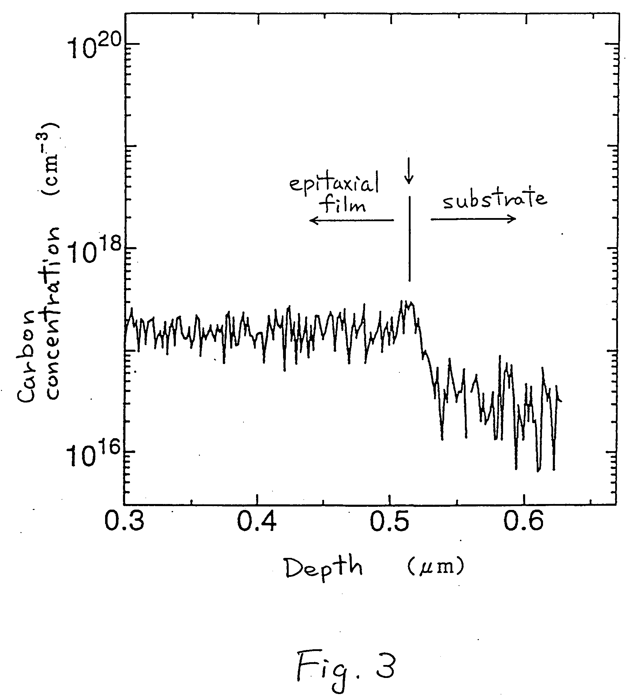

The partial pressure during growth was set to be lower than in Example 1. The epitaxial film was made of Si₁₋ₓGeₓ in this example. The growth temperature was 700°C, and the partial pressures of Si₂H₆ and GeH₄ were both 5 × 10⁻⁵ Torr. Fig. 3 shows the results of measurement by SIMS of the carbon distribution along the depth of the epitaxial film grown in this way. The epitaxial film formed in the present example had no carbon concentration peak at the epitaxial film-silicon substrate interface. This is believed to be the result of the decreased growth rate due to the lower partial pressures during the growth, and the resultant relatively increased rate of the upward movement of the carbon as compared with the growth rate. This promoted the upward movement of the carbon to cause segregation of most of the carbon at the initial interface to the surface of the epitaxial film. When compared with the result of the growth at 625°C according to the conventional technique (see Fig. 4), the carbon concentration at the epitaxial film-silicon substrate interface was 1/100 or lower.

The epitaxial film formed as described above was subjected to thermal treatment at 950°C for 5 minutes to enhance any defect formation etc. if any, and then observed with a transmission electron microscope, which resulted in no detection of silicon carbide precipitation. In addition, with an NPN-type HBT (Hetero Bipolar Transistor) having a base layer composed of the Si₁₋ₓGeₓ fabricated in the present example, the leakage current passing across the collector/base was smaller. More specifically, when a reverse bias of 5 V was applied to an HBT having a conventional base layer, the leakage current was 10⁻⁸ A/µm², whereas the leakage current observed with the HBT comprising the epitaxial film fabricated in the present example was 10⁻¹³ A/µm².

In the examples described above, the growth was performed at a substrate temperature of 700°C. Although this temperature could be in the range of 650°C to 800°C, in order to fully eliminate the effect of silicon carbide formation, the growth temperature should preferably be less than 775 °C. It should also be noted that the epitaxial film may be doped with impurities such as boron or phosphorus using appropriate material gases. Furthermore, the aqueous hydrogen fluoride solution treatment may be substituted by gaseous hydrogen fluoride treatments as well as other vapour phase treatments capable of removing silicon oxide from a silicon surface.

As described above, the use of a growth temperature of 650°C to 800°C, inclusive, according to the present invention produces the effect of significantly reducing the carbon quantity at the interface between the epitaxial film and the silicon substrate to, for example, 1/100 or less as compared with the performance of the conventional method, and thus contributes greatly to improved characteristics of the device. In addition, the treatment with an aqueous hydrogen fluoride solution, which is performed as the pretreatment for the growth of the epitaxial film, has the effect of lowering the maximum ultimate temperature during the process and thus preventing adverse effects resulting from diffusion of boron, phosphorus, etc.

While the present invention has been described in connection with certain preferred embodiments, it is to be understood that the subject matter encompassed by way of the present invention is not to be limited to those specific embodiments. On the contrary it is intended for the subject matter of the invention to include all alternatives , modifications and equivalents as can be included within the spirit and scope of the following claims.

## Claims

1. A method of growing an epitaxial film on a silicon substrate comprising the steps of:
removing silicon oxide from a surface of said silicon substrate by a hydrogen fluoride treatment; and
growing an epitaxial film on said hydrogen fluoride treated surface at a growth temperature of 650°C to 775°C using ultrahigh-vacuum chemical vapor deposition.

2. A method of growing an epitaxial film on a silicon substrate comprising the steps of:
removing a silicon oxide film from a surface of said silicon substrate with an aqueous hydrogen fluoride solution treatment; and
growing an epitaxial film material including silicon on said treated surface using ultrahigh-vacuum chemical vapor deposition, wherein a substrate temperature during said growth is in a range of 650°C to 775°C, and a partial pressure of a material gas during said growth is 5 × 10⁻⁴ Torr or lower.

3. The method of growing an epitaxial film as claimed in claim 1 or 2, wherein the surface of said silicon substrate is of (001) plane orientation.

4. The method of growing an epitaxial film as claimed in claim 1 or 2, wherein said epitaxial film is composed of silicon or a silicon-germanium alloy.

5. The method of growing an epitaxial film as claimed in claim 1 or 2, wherein said epitaxial film is composed of silicon or a silicon-germanium alloy and at least one of disilane (Si₂H₆) and germane (GeH₄) is used as said material gas.

6. A method of growing an epitaxial film on a silicon substrate comprising the steps of:
removing a silicon oxide film from a surface of said silicon substrate with an aqueous hydrogen fluoride solution treatment; and
growing an epitaxial film material including silicon on said treated surface using ultrahigh-vacuum chemical vapor deposition, wherein a substrate temperature during said growth is 700°C, and a partial pressure of a material gas for said epitaxial during said growth is 5 × 10⁻⁵ Torr.

7. The method of growing an epitaxial film as claimed in claim 1 or 2, wherein a temperature of said substrate never exceeds 800°C after said hydrogen fluoride treatment and before completion of said growth.
